# EUROPEAN PATENT APPLICATION

(11) **EP 4 851 341 A1**
(43) Date of publication of application: **09.12.2026**
(21) Application number: 25180664.2
(22) Date of filing: 04.06.2025
(51) Int. Cl.: C30B 15/00, C30B 29/52, C30B 15/02

(54) **METHOD OF REDUCING PHASE SEGREGATION DURING PRODUCTION OF ALLOYS**

(71) Applicant: Max-Planck-Gesellschaft zur Förderung der Wissenschaften e.V., 80539 München (DE)
(72) Inventor: HE, Bin, 01187 Dresden (DE); FELSER, Claudia, Dr., Prof., 01187 Dresden (DE)
(74) Representative: Schweitzer, Klaus

(57) **Abstract**

The present invention relates to an apparatus and a method for the production of large single crystals of an alloy, which has the target molar composition of AₓB_{y} in the solid state, which alloy exhibits a gap between the liquidus and the solidus in its phase diagram. The invention also relates to the use of the apparatus and the method for growing single crystals with phase segregation during the crystal growth process.

## Description

### FIELD OF THE INVENTION

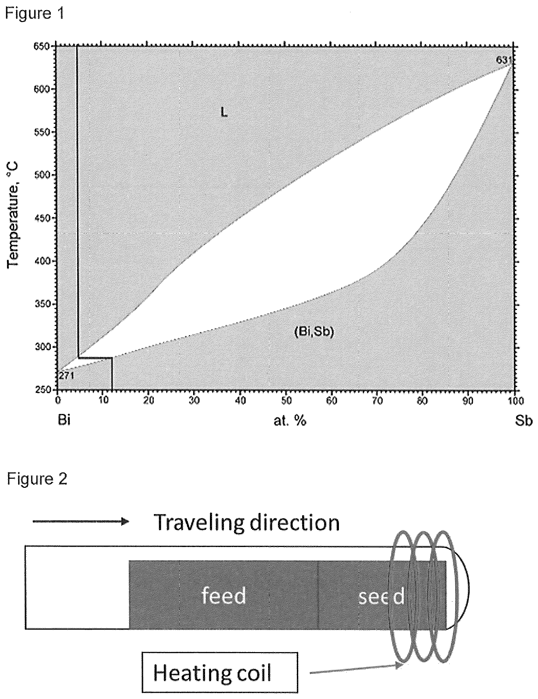

The present invention pertains to the technical field of a crystal growth method for materials, which exhibit a pronounced phase segregation as it occurs e.g. in Bi-Sb alloys during production (see **Figure 1**). Phase segregation in alloys refers to the phenomenon where different phases or regions with distinct compositions form within the material, due to the nonuniform distribution of alloying elements during processes like solidification or heat treatment. It can lead to variations in mechanical, chemical, and physical properties, which may affect the performance of the alloy.

### BACKGROUND

Thermoelectric technology is able to convert heat into electricity, or vice versa. Unlike the well-established high temperature waste heat recovery, very few materials show promising low temperature cooling performance due to a small Seebeck coefficient. To solve this low performance, topological thermoelectric materials based on single crystals are discovered to have better performance below room temperature.

The Bi-rich Bi-Sb alloy is the first established three-dimensional topological insulator. When the Sb is less than 8% mol fraction, the alloy is a Dirac semimetal. When the Sb is more than 8%, it is a topological insulator. In the topological insulator phase, the material has been determined to have a thermoelectric figure of merit zT of 1.7 (at 200 K and 0.7 T) and a zT of 2.6 (at 100 K and 0.4 T after doping with 10 ppm of Tellurium). [1,2]

To obtain this high zT, a high-quality single crystal of an exact chemical composition is required. As of today, the method used for crystal growth is mainly a horizontal zone melting method (see **Figure 2**), but this method suffers from the super cooling induced by the phase segregation while the material is cooled from melt. This leads to varying chemical compositions in the grown crystals, which results in too much waste since only a certain fraction of the grown crystal has the exact required composition.

For topological single crystals, there are multiple techniques applied to grow high quality single crystals.

The Bridgmann technique is often used to produce large quantity of crystals, such as Heulser alloys, InSb crystals etc. But the Bridgmann method cannot solve the phase segregation problem in Bi-Sb alloys.

Chemical vapor transport is another commonly used method, which is good for chalcogenides and halides. However, Bi has a very low vapor pressure so that it barely travels even with a traveling material like l₂.

The flux method is good for producing small amounts of crystals. It requires the product to precipitate from a solvent. The technique is powerful, but the method itself is too unproductive.

### OBJECT OF THE INVENTION

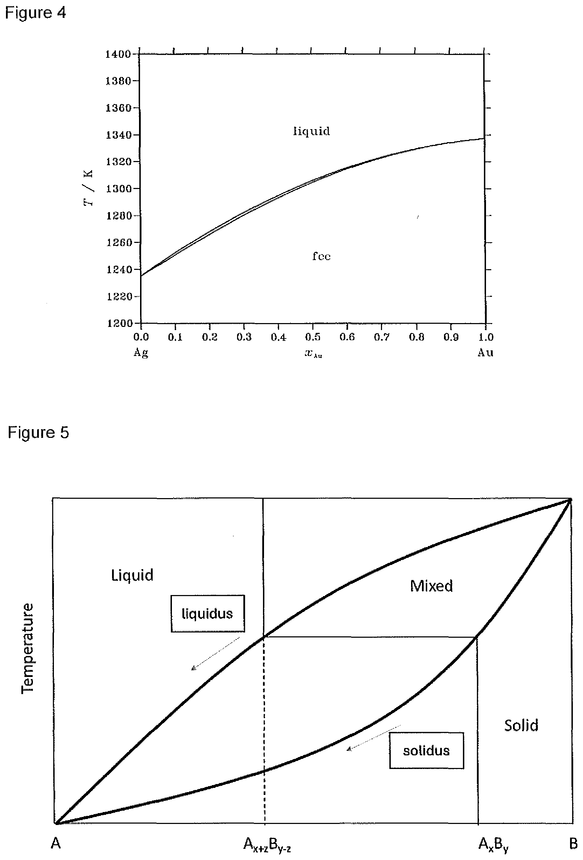

It was an object of the present invention to improve the manufacturing method for alloys which exhibit the phenomenon of phase segregation due to a pronounced gap between the liquidus and the solidus in the composition-ratio/temperature phase diagram (see **Figure 1** **and** **5**). Other alloys, such as Ag-Au alloys, where the two noble elements have full solubility into each other, do not suffer from the phase segregation problem because their liquidus and solidus are nearly identical, so that a molten composition of AgₚAu_{q} will also crystallize as AgₚAu_{q} (see **Figure 4**). It was the specific object of the present invention to improve the manufacturing process for the production of alloys which exhibit the phenomenon of phase segregation due to a pronounced gap between the liquidus and the solidus so that the obtained crystals have a large size e.g. with a diameter of ≥2.5 cm and a length of ≥25 cm and an inhomogeneity of molar chemical composition across the crystal of less than 10 mol-%.

### BRIEF DESCRIPTION OF THE INVENTION

The present inventors have found that by controlling the seed and feed compositions in a manufacturing method called the Czochralski method one can produce large single crystals and one can control the composition with the precision to 10 mol-% or even less.

The Czochralski method is an industrially used process to produce large single crystals, such as silicon or GaAs single crystals. Its large-scale production allows the crystals to have large size and high quality. In this method a pre-defined composition of the to be crystallized material is molten and a seed crystal of the desired composition is lowered onto the top of the melt so that it just barely touches the surface of the melt. Subsequently the seed crystal is slowly pulled upwards, resulting in a continued growing of the seed crystal. As such the Czochralski method is also not useful for the production of large single crystals of alloys, which exhibit a gap between the liquidus and the solidus in the phase diagram because of the super cooling induced by the phase segregation while the material is cooled from melt. Like in the horizontal zone melting method mentioned above, this leads to varying chemical compositions in the grown crystals, which results in too much waste since only a certain fraction of the grown crystal has the exact required composition.

The present inventors have modified the Czochralski method so that it can be used for the production of large single crystals of alloys, which exhibit a gap between the liquidus and the solidus in the phase diagram but, nevertheless, have an inhomogeneity of molar chemical composition across the crystal of less than 10 mol-%.

Accordingly, the present invention concerns a method for the production of large single crystals of an alloy, which has the target molar composition of AₓB_{y} in the solid state, which alloy exhibits a gap between the liquidus and the solidus in its phase diagram, which method comprises
- melting
   ▪ an alloy composition of x+z mol-% A and y-z mol-% B if B is the higher melting component of the alloy AₓB_{y},
      or
   ▪ an alloy composition of x-z mol-% A and y+z mol-% B if A is the higher melting component of the alloy AₓB_{y},
- placing a solid seed crystal of AₓB_{y} onto the melt, so that it touches the melt at its surface
- pulling the seed crystal away from the surface of the melt, and
- cooling the crystal, wherein
   - A: is a first component of the alloy AₓB_{y}
   - B: is a second component of the alloy AₓB_{y}
   - x: is the molar percentage of the first alloy component A, and
   - y: is the molar percentage of the second alloy component B, and
   - z: is the difference in molar percentage between the molar composition of the liquid phase of the alloy and the molar composition of the solid phase of the alloy AₓB_{y}, at a given temperature, wherein the component of the differing molar percentage is called the vanishing higher melting component of the alloy AₓB_{y.},
   wherein the solid alloy composition AₓB_{y} has an inhomogeneity of molar chemical composition across the crystal of less than 10 mol-%.

### BRIEF DESCRIPTION OF THE DRAWINGS

The accompanying drawings are included to provide a more detailed understanding of the invention. The drawings illustrate exemplary embodiments of the present invention and, together with the description, serve to explain the principles of the present invention.
Figure 1 shows the phase diagram of Bi-Sb alloy, with a clear segregation between the solidus and liquidus.
Figure 2 shows the classic horizontal travelling-molten-zone method.
Figure 3 shows the design of the modified Czochralski furnace according to the present invention.
Figure 4 shows the phase diagram of an Ag-Au alloy with nearly no phase segregation between the solidus and the liquidus.
Figure 5 shows the same phase diagram as shown in figure 1 with a more detailed view of the phase segregation, where the solidus and liquidus separate. In order to grow a composition of AₓB_{y} in the solid phase with a clear phase segregation, one needs to start with a different liquid phase, i.e., A_{x+z}B_{y-z}.

### DETAILED DESCRIPTION OF THE INVENTION

The present inventors have found that it is possible to apply a modified Czochralski method technique to grow large quantities of high-quality single crystals of alloys, which have the molar composition of AₓB_{y} in the solid state, and which alloys show a gap between the liquidus and the solidus in the phase diagram.

In general, the Czochralski method is industrially used to grow e.g. silicon single crystals to the size of up to 30 cm.

The Czochralski method involves a chamber of molten material, and a seed crystal of the desired alloy composition at the top of the melt. The seed crystal slightly touches the melt and is slowly pulled up, preferably with rotation. As a result, the crystal will grow with the pulling process.

According to the phase diagram, the classic Czochralski method will not work properly with alloys, which exhibit a gap between the liquidus and the solidus in the phase diagram, such as Bi-Sb alloys (see **Figures 1** **and** **5**), because the formation of the solid will reduce the amount of one of the alloy components - for an Bi-Sb alloy it is Sb - in the melt, which - in turn - will create a composition gradient in the grown crystal, i.e. the composition of the crystal changes with its length.

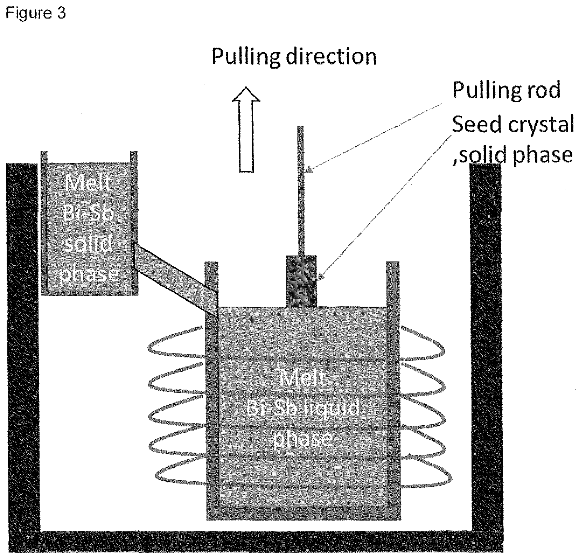

To solve this problem, according to the present invention, one starts with an adapted enriched alloy mixture. The melt feeding can e.g. be achieved with the aid of a secondary feed-channel or a supplementary melt chamber, which is connected to the primary melt-chamber, and which functions to add the enriched alloy liquid to the melt, to compensate for the mass loss due to the removed single crystal, see **Figure 3****.** The secondary feed-channel, or the supplementary chamber is preferably used to supply the alloy components in the liquid form. Generally, it is advantageous to supply a liquid form since liquids can mix more gently and create less perturbation to the melt and grow better quality crystals.

The melt at least in the primary melt-chamber is preferably maintained at a (constant) temperature of ±20°C, preferably ± 10°C, more preferred ± 5°C and most preferred ± 1°C of the solidification temperature (=solidus temperature) of the target alloy AₓB_{y}.

The crystal growth can be controlled to the speed of 2 mm, preferably 1 mm and more preferred to 0.5 mm per hour. When the additional liquid, enriched with the vanishing higher melting component of the alloy AₓB_{y} is added, the melt is preferably constantly stirred to homogenize the composition and to make sure no concentration gradient is formed in the melt.

The pulling process can be paused several minutes per hour, e.g. 10 min per hour, preferably 7 min per hour and more preferred 5 min per hour, to allow the mixing of the original and supplied liquids and further homogenize the crystal.

Preferred candidates for alloys, which may exhibit a gap between the liquidus and the solidus in the phase diagram, and which, therefore, may suffer from a phase segregation in their crystal growth are certain three-dimensional topological insulators or topological semimetals, including but not limited to:
Bi-Sb alloys, Bi₂Te₃-Bi₂Se₃ alloy, HgTe-CdTe alloy.
In a preferred embodiment single crystal of topological materials, particularly Bi-Sb alloys can be grown with high quality.

### DEFINITION OF TERMS

For the purpose of this invention the following terms (whether used in singular or plural) shall have the following meaning:

*Single crystal* means a solid material where the entire structure is continuous and unbroken, with no grain boundaries. This means the atoms are arranged in a perfectly ordered, repeating pattern - the so-called unit cells - throughout the entire specimen.

*Alloy* shall mean a mixture of two or more elements or chemical compounds, at least one of which is a metal. Alloys are engineered to enhance certain properties, such as strength, malleability, corrosion resistance, or electrical conductivity.

*Components of an alloy* are typically referred to as its constituent elements, which typically include a base material, an alloying material and optionally an impurity material. For example, in Te doped Bi₈₈Sb₁₂, Bi is the base material, Sb is the alloying material and Te is the impurity material, which is also a dopant. All three are components of the alloy.

*Alloy composition* refers to the specific components and their respective molar or atomic proportions within the mixture.

A *phase diagram* is a graphical representation that shows the relationship between temperature and the composition of a substance or mixture (see Figures 1, 4 and 5). It illustrates the different phases (solid, liquid, gas) that a material can exist in under varying conditions. Typically, alloys start to melt at the temperature known as the solidus, and completely melt at the temperature called liquidus. The solidus is always less than or equal to the liquidus. If a gap exists between the solidus and liquidus, it is called the freezing range, and within that gap, the substance consists of a mixture of solid and liquid phases, which creates the problem of phase segregation in the process of crystal growth.

A *seed crystal* is a small crystal with the designed composition, used to pull the larger crystal out from the melt. The size of the seed crystal depends on the need for the intended use. For the purpose of the present invention, typically, the seed crystal should be at least 10 mm, more preferably 15mm long to ensure safe fastening by a gripper. The surface of the seed crystal which shall touch the surface of the melt should be the desired lattice plane of the crystal, for instance, the (1,1,1) plane of Bi-Sb alloy. This desired lattice plane depends on the intended use and is known to those skilled in the art.

*Molar percentage* is a way of expressing the composition of an alloy or a compound in terms of the number of moles of each component relative to the total number of moles in the mixture. When the components are elements, the molar percentage corresponds to the *atomic percentage.*

Z is the difference in molar percentage between the molar composition of the liquid phase of the alloy and the molar composition of the solid phase of the alloy, at a given temperature, wherein the component of the differing molar percentage is called the vanishing higher melting component of the alloy AₓB_{y}

The *inhomogeneity* of molar chemical composition is the molar fraction of the grown crystal, which does not possess the desired target composition AₓB_{y} across the crystal. According to the present invention this inhomogeneity is less than 10 mol-%, preferably less than 5 mol-% and more preferred less than 1 mol-%.

### APPARATUS & PROCESS

The apparatus for performing the modified Czochralski method according to the present invention comprises:
- A main melt-chamber, which typically is a stainless steel crucible. Yet, depending on the material to be melted also zirconium dioxide (ZrO₂), aluminum oxide (Al₂O₃) or a high melting non-alloying metal, e.g. Ta can be used as material for the melt-chamber. Even more preferred, tungsten carbide (WC) is used. The chamber is typically heated with a graphite heater, or an induction coil, and it should preferably be kept under an inert gas atmosphere, e.g. argon or nitrogen atmosphere to prevent possible oxidation.
- Eventually a supplementary melt-chamber, which is connected to the main melt-chamber in order to feed the adapted enriched alloy composition. Depending on the crystal being grown, the supplementary chamber should be made of the same material used for the main melting chamber, for instance stainless steel, preferably ZrO₂, more preferably WC. Eventually used connecting parts preferably share the same composition as the main chamber and the supplementary chamber.
- A pulling device like a pulling rod for pulling a solid seed crystal of the solid alloy composition AₓB_{y} out of the melt. The travelling speed should be no higher than 2 mm per hour preferably 1 mm and more preferred 0.5 mm per hour, in order to prevent phase segregation. Preferably the pulling device can be rotated with a rotating speed of between 1 to 10 rpm, preferably 1 to 5 rpm, more preferred 1 to 3 rpm. A step motor or a servomotor can be used to precisely control the motion during the crystal growth. The crystal can be attached to the motor by e.g. a gripper, or directly welded to the end of the pulling rod.
- Eventually a cooling device for cooling the crystal. For example, the crystal can be cooled down with a fan, preferably using an inert gas like argon or nitrogen.

### APPLICATIONS

The new process and furnace can generally be used to grow single crystals with phase segregation during the crystal growth process.

### References:

1.B. He et al. Energy Environ. Sci.18, 3376-3384 (2025).
2. Y. Pan et al. Nat. Mater. 24, 76-82 (2025).

## Claims

1. Method for the production of large single crystals of an alloy, which has the target molar composition of AₓB_{y} in the solid state, which alloy exhibits a gap between the liquidus and the solidus in its phase diagram, which method comprises
- melting
▪ an alloy composition of x+z mol-% A and y-z mol-% B if B is the higher melting component of the alloy AₓB_{y},
or
▪ an alloy composition of x-z mol-% A and y+z mol-% B if A is the higher melting component of the alloy AₓB_{y},
- placing a solid seed crystal of AₓB_{y} onto the melt, so that it touches the melt at its surface
- pulling the seed crystal away from the surface of the melt, and
- cooling the crystal, wherein
A is a first component of the alloy AₓB_{y}
B is a second component of the alloy AₓB_{y}
x is the molar percentage of the first alloy component A, and
y is the molar percentage of the second alloy component B, and
z is the difference in molar percentage between the molar composition of the liquid phase of the alloy and the molar composition of the solid phase of the alloy AₓB_{y}, at a given temperature, wherein the component of the differing molar percentage is called the vanishing higher melting component of the alloy AₓB_{y.},
wherein the solid alloy composition AₓB_{y} has an inhomogeneity of molar chemical composition across the crystal of less than 10 mol-%.

2. Method according to claim 1, wherein the crystal growth is controlled to the speed of 2 mm per hour.

3. Method according to claim 1 or 2, wherein the melt is constantly stirred.

4. Method according to one of claims 1-3, wherein the pulling process is paused for 10 min per hour, preferably for 7 min per hour.

5. Method according to one of claims 1-4, wherein the seed crystal has a length of 10 mm, preferably 15 mm.

6. Method according to one of claims 1-5, wherein the inhomogeneity is less than 5 mol-%, preferably less than 1mol-%.

7. Apparatus for performing a modified Czochralski method comprising:
- a main melt-chamber,
- a supplementary melt-chamber and
- a pulling device.

8. Apparatus according to claim 7, wherein the melt-chamber and optionally also the supplementary melt-chamber is made of stainless steel, zirconium dioxide (ZrO₂), aluminum oxide (Al₂O₃) or a high melting non-alloying metal or tungsten carbide (WC).

9. Apparatus according to claim 7 or 8, wherein the supplementary melt-chamber is connected to the main melt-chamber, preferably using connecting parts, which preferably share the same composition as the main chamber and the supplementary chamber.

10. Apparatus according to claim 7, 8 or 9, wherein the pulling device is a pulling rod.

11. Apparatus according to one of claims 7-10, wherein the pulling device is rotatable with a rotating speed of between 1 to 10 rpm.

12. Apparatus according to one of claims 7-11, further comprising a cooling device for cooling the crystal.

13. Apparatus according to claim 12, wherein the cooling device comprises a fan using an inert gas.

14. Use of the process according to claim 1 for growing single crystals with phase segregation during the crystal growth process.

15. Use of the apparatus according to claim 7 for growing single crystals with phase segregation during the crystal growth process.
